(19) Europäisches Patentamt / European Patent Office / Office européen des brevets

(11) **EP 4 318 328 A1**

(12) **EUROPEAN PATENT APPLICATION**
published in accordance with Art. 153(4) EPC

(43) Date of publication:
**07.02.2024 Bulletin 2024/06**

(21) Application number: **22815259.1**

(22) Date of filing: **31.05.2022**

(51) International Patent Classification (IPC):
*G06N 10/00* (2022.01)

(52) Cooperative Patent Classification (CPC):
**G06N 10/00; G06N 10/20; G06N 10/40**

(86) International application number:
**PCT/CN2022/096176**

(87) International publication number:
**WO 2022/253214 (08.12.2022 Gazette 2022/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.06.2021 CN 202110625588**

(71) Applicant: **Origin Quantum Computing Technology (Hefei) Co., Ltd**
**Hefei, Anhui 230088 (CN)**

(72) Inventors:
• ZHAO, Yongjie
  **Hefei, Anhui 230088 (CN)**
• KONG, Weicheng
  **Hefei, Anhui 230088 (CN)**

(74) Representative: **Murgitroyd & Company**
**Murgitroyd House**
**165-169 Scotland Street**
**Glasgow G5 8PL (GB)**

(54) **QUANTUM STATE INFORMATION PROCESSING SYSTEM, QUANTUM MEASUREMENT AND CONTROL SYSTEM AND QUANTUM COMPUTER**

(57) Disclosed are a quantum state information processing system, a quantum measurement and control system, and a quantum computer. In this system, a sampling module is used to perform sampling processing on an analog signal collected from a qubit, a frequency mixing module is used to perform mixing processing on the sampled signal, a demodulation module is used to perform demodulation processing on a mixed signal, and a determining module is used to perform state classification on a demodulated signal by using a state classification equation, so as to acquire quantum state information. Embodiments of the present disclosure provide a hardware system architecture, which fills a technical gap of a hardware system for parsing a quantum state of a qubit in conventional technologies.

FIG. 1

**Description**

**CROSS-REFERENCE TO RELATED APPLICATIONS**

This application claims priority to Chinese Patent Application No. CN202110625588.X, filed on June 4, 2021 and entitled "QUANTUM STATE INFORMATION PROCESSING SYSTEM, QUANTUM MEASUREMENT AND CONTROL SYSTEM, AND QUANTUM COMPUTER", which is incorporated herein by reference in its entirety.

**TECHNICAL FIELD**

The present disclosure relates to the quantum computation field, and in particular, to a quantum state information processing system, a quantum measurement and control system, and a quantum computer.

**BACKGROUND**

Quantum state information refers to a quantum state of a qubit, and basic quantum states include state $|0\rangle$ and state $|1\rangle$. After the qubit is operated, the quantum state of the qubit changes. It is reflected that on a quantum chip, after the quantum chip is executed, a quantum state of the qubit changes, that is, execution result of the quantum chip is obtained. The execution result is carried and transmitted by a qubit readout signal (generally an analog signal). Rapidly parsing a quantum state of a qubit by using a qubit reading signal is a key work for understanding execution performance of a quantum chip. There is no hardware system for effectively parsing a quantum state of a qubit in conventional technologies.

Therefore, how to provide a hardware system for parsing a quantum state of a qubit becomes a technical problem to be urgently solved by those skilled in the art.

**SUMMARY**

An objective of embodiments of the present disclosure is to provide a quantum state information processing system, a quantum measurement and control system, and a quantum computer, to solve a problem of lacking a hardware system for effectively parsing a quantum state of a qubit in conventional technologies.

An embodiment of the present disclosure provides a quantum state information processing system, where quantum state information is included in an analog signal collected from a qubit, and the quantum state information processing system includes:

a sampling module, configured to perform sampling processing on the analog signal to output a sampled signal;
a frequency mixing module, configured to perform mixing processing on the sampled signal to output a mixed signal;
a demodulation module, configured to perform demodulation processing on the mixed signal to output a demodulated signal; and
a determining module, configured to perform state classification on the demodulated signal by using a state classification equation, to output the corresponding quantum state information, where the state classification equation is preconfigured and used to distinguish from different quantum states.

Optionally, the demodulation module includes:

a filter, configured to perform filtering processing on the mixed signal to output a filtered signal; and
an accumulator, configured to perform integration processing on the filtered signal according to an operating time of the filter to output the demodulated signal.

Optionally, the filter includes N adders, the N adders are classified into a plurality of sub-combinations, and adders in each sub-combination synchronously execute an addition operation.

Optionally, the filter further includes a first multiplier, the plurality of sub-combinations are connected in a cascaded manner, the first sub-combination of the filter includes $\lceil N/2 \rceil$ adders, input of the first sub-combination is output of the first multiplier, and input of a sub-combination at a current stage in cascade is output of a sub-combination at a previous stage.

Optionally, the frequency mixing module includes:

a numerically controlled oscillator, configured to output a local oscillator signal; and
a second multiplier, configured to multiply the local oscillator signal and the sampled signal to output the mixed signal.

Optionally, the determining module includes:

a position determiner, configured to substitute the demodulated signal into the state classification equation to output a first numerical value; and
a state determiner, configured to output the corresponding quantum state information based on the first numerical value.

Optionally, the quantum state information processing system further includes:
an enabling module, configured to provide an enabling signal for each module in the quantum state information processing system based on an operating time of the quantum-state information processing system.

Optionally, the quantum state information processing system further includes:

a bit width control module, configured to truncate the demodulated signal based on a binary shift operation to adjust a bit width of the demodulated signal.

Optionally, the sampling module includes an ADC.

Optionally, the sampling module, the frequency mixing module, the demodulation module, and the determining module are implemented by using an FPGA, a DSP, or an MCU.

An embodiment of the present disclosure further provides a quantum measurement and control system, including the quantum state information processing system according to any one of the foregoing feature descriptions, where the quantum state information processing system is configured to acquire corresponding quantum state information from output information of a qubit.

An embodiment of the present disclosure further provides a quantum computer, including the quantum measurement and control system.

Compared with the conventional technologies, an embodiment of the present disclosure may have the following beneficial effects.

In the quantum state information processing system provided in the embodiment, a sampling module is used to perform sampling processing on an analog signal collected from a qubit, a frequency mixing module is used to perform mixing processing on the sampled signal, a demodulation module is used to perform demodulation processing on a mixed signal, and a determining module is used to perform state classification on a demodulated signal by using a state classification equation, so as to acquire quantum state information. According to the quantum state information processing system in the present application, a hardware system architecture is provided, which fills a technical gap of a hardware system for parsing a quantum state of a qubit in conventional technologies.

The quantum measurement and control system and the quantum computer provided in the embodiments belong to a same inventive concept with the quantum state information processing, and therefore have same beneficial effect, and details are not described herein again.

**BRIEF DESCRIPTION OF THE DRAWINGS**

FIG. 1 is a schematic structural diagram of a quantum state information processing system according to an embodiment of the present disclosure.
FIG. 2 is a schematic structural diagram of the filter in FIG. 1.
FIG. 3 is a schematic structural diagram of a conventional pipeline structure adder.
FIG. 4 to FIG. 7 are schematic structural diagrams of an adder according to an embodiment of the present disclosure.

Fig. 8 is a schematic structural diagram of the numerically controlled oscillator in FIG. 1.

**DETAILED DESCRIPTIONS OF THE EMBODIMENTS**

The following describes specific implementations of the present disclosure with reference to the accompanying drawings. The advantages and features of the embodiments will be more apparent based on the following descriptions and claims. It should be noted that, the accompanying drawings all use a very simplified form and a non-accurate proportion for conveniently and clearly assisting in description of the embodiments.

In the description of the present disclosure, it should be understood that, orientations or position relationships indicated by the terms "center", "on", "below", "left", "right", and the like are orientations or position relationships based on the accompanying drawings. These terms are merely intended to facilitate the description of the present disclosure and simplify the description, rather than indicating or implying that the referred apparatus or element must have a particular orientation or be constructed and operated in a particular orientation. Therefore, these terms should not be interpreted as limiting embodiments of the present disclosure.

In addition, the terms "first", "second", and the like are merely intended for a purpose of description, and shall not be understood as an indication or implication of relative importance or implicit indication of the number of indicated technical features. Therefore, the features defined by "first", "second", and the like may indicate or imply that one or more of the features are included. In the descriptions of the present disclosure, "a plurality of" means at least two, for example, two or three, unless otherwise specifically stated.

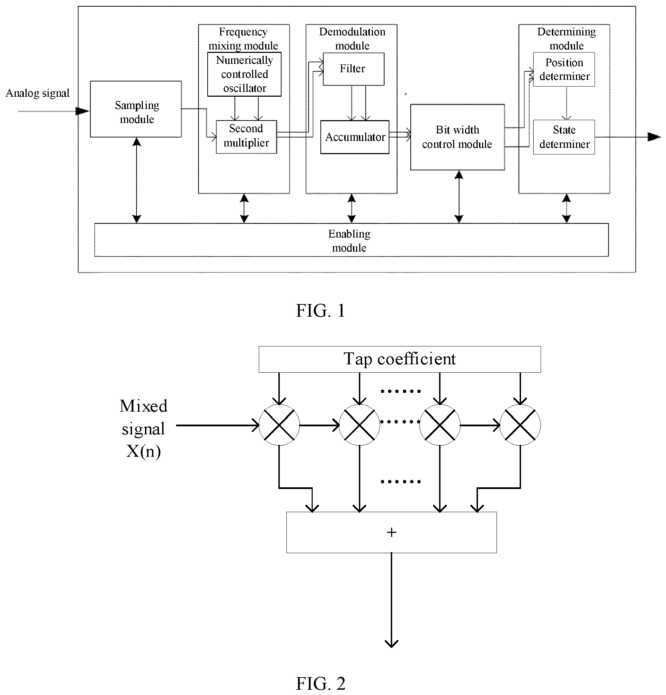

Referring to FIG. 1, an embodiment provides a quantum state information processing system, where quantum state information is included in an analog signal collected from a qubit, and the quantum state information processing system includes a sampling module, a frequency mixing module, a demodulation module, and a determining module. The sampling module is configured to perform sampling processing on the analog signal to output a sampled signal; the frequency mixing module is configured to perform mixing processing on the sampled signal to output a mixed signal; the demodulation module is configured to perform demodulation processing on the mixed signal to output a demodulated signal; and the determining module is configured to perform state classification on the demodulated signal by using a state classification equation, to output the corresponding quantum state information, where the state classification equation is preconfigured and used to distinguish from different quantum states.

Different from conventional technologies, the quantum state information processing system provided in this embodiment uses the sampling module to perform sampling processing on an analog signal acquired from a qubit, the frequency mixing module to perform mixing processing on a sampling signal, the demodulation module to perform demodulation processing on a mixed signal, and the determining module to perform state classification on a demodulated signal by using a state classification equation, so as to acquire quantum state information. According to the quantum state information processing system in the present application, a hardware system architecture is provided, which fills a technical gap of a hardware system for parsing a quantum state of a qubit in the conventional technologies. In this embodiment, the sampling module may be implemented by using an analog to digital converter (Analog to Digital Converter, ADC). The quantum state information processing system may be implemented by using a field programmable gate array (Field Programmable Gate Array, FPGA), a digital signal processor (Digital Signal Process, DSP) or a microcontroller unit (Microcontroller Unit, MCU ), and the sampling module, the frequency mixing module, the demodulation module, and the determining module may be integrated into the FPGA, the DSP or the MCU. A parsing process of a qubit readout signal may generally be roughly divided into IQ demodulation, filtering and integration. In this parsing process, communication between a qubit measurement and control system and a PC may be established in principle, and then the parsing process is performed on collected data on the PC to complete parsing of quantum state information. However, the solution of using a PC to implement parsing of quantum state information is unacceptable in terms of data processing delay relative to a typical coherence time at a microsecond level of a superconducting qubit, and de-coherence of a qubit will completely lose real-time performance of the quantum state information. The inventors found that using an FPGA to implement parsing of quantum state information may complete all data processing procedures required in a time at hundreds of nanoseconds level or even tens of nanoseconds level. Therefore, in this embodiment, the quantum state information processing system is preferably implemented by using an FPGA.

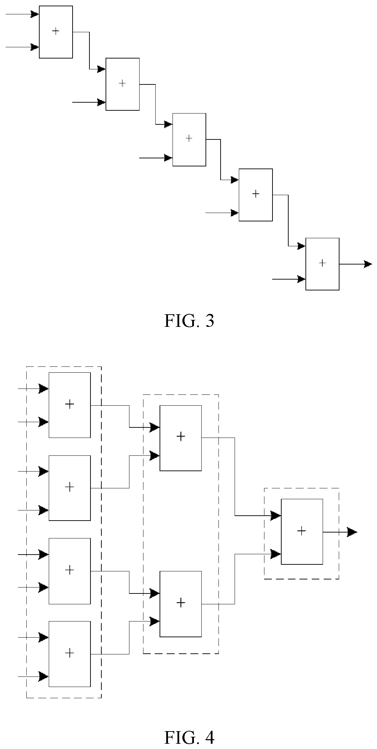

Specifically, referring to FIG. 1, the demodulation module may include a filter and an accumulator. The filter is configured to perform filtering processing on the mixed signal to output a filtered signal The accumulator is configured to perform integration processing on the filtered signal according to an operating time of the filter to output the demodulated signal. The filter in the demodulation module is generally designed as a low-pass finite impulse response (Finite Impulse Response, FIR) filter, which is configured to filter out a high-frequency component in the signal, and only direct current information is retained. The operation performed by the filter is essentially an operation of convolution sum, and if an order of the filter is N, data output by the filter each time is a sum of N+1 products. For an FPGA, N+1 multiplications and N additions need to be completed within one clock cycle, and multiplications may be completed in a multi-way parallel manner; however, N addition operations need to be completed in a pipeline manner. Referring to FIG. 3, FIG. 3 is an existing adder structure in a pipeline manner. Even symmetry of coefficients of the FIR filter is considered, a conventional pipeline solution still brings about a data delay of $\lceil (N+1)/2 \rceil$ clock cycles, and the symbol $\lceil \ \rceil$ represents rounding up. Based on the above finding, the inventors further improve a structure of a conventional adder to solve the problem of large data delay. This solution may be referred to as "folding in half" addition, and its schematic principle is shown in FIG. 4. In an N-number adder structure designed by optimization, a data delay introduced is $\lceil log_2(N+1) \rceil$ clock cycles. A filter module designed by optimization greatly reduces a delay of data processing. For example, assuming that a working frequency of an FPGA is 200 MHz, for a 99-order filter, an original design needs a data delay of 50 clock cycles, while a new solution only needs a delay of 7 clock cycles, reducing 215 ns.

A specific structure of a filter is described briefly in the following. Referring to FIG. 2 and FIG. 4, the filter includes N adders, the N adders are classified into a plurality of sub-combinations, and adders in each sub-combination synchronously execute an addition operation. The filter in the demodulation module is composed of N adders, the N adders are divided into a plurality of sub-combinations, and adders in each sub-combination synchronously execute an addition operation. Compared with an existing filter using a pipelined structure to process an addition operation, a filter structure according to the present application may reduce a delay of data processing to a specific extent. The filter further includes a first multiplier; and the plurality of sub-combinations are connected in a cascaded manner. The first sub-combination of the filter includes [N/2] adders, and the symbol $\lceil \ \rceil$ represents rounding up. Input of the first sub-combination is output of the first multiplier, and input of a sub-combination at a current stage in cascade is output of a sub-combination at a previous stage. One input of the first multiplier is configured to receive a tap coefficient of the filter, and the other input is configured to receive a mixed signal.

A structure of the plurality of adders may be set in the following manners. When a quantity of first multipliers is an even number, if a quantity of outputs of each sub-combination is an even number, the plurality of adders are arranged according to the following structure: A quantity of adders in a sub-combination at a previous stage is twice a quantity of adders, connected to the adders at the previous stage, in a sub-combination at a current stage, and reference may be made to the structure shown in FIG. 4.

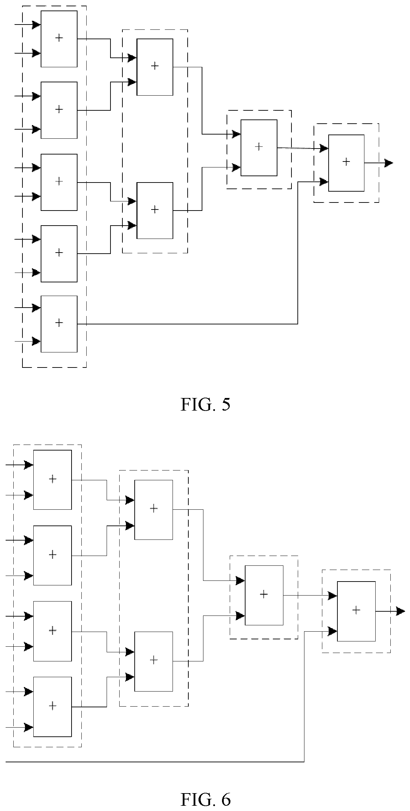

If a quantity of outputs of a specific sub-combination is an odd number, the sub-combination is defined as a redundant sub-combination, the plurality of adders are arranged according to the following structure: An adder is added following a sub-combination at the last stage, and the adder is defined as a first redundancy adder. Two input terminals of the redundancy adder are respectively connected to an output of the last sub-combination and an output of the redundancy sub-combination, and reference may be made to the structure shown in FIG. 5.

When the quantity of the first multipliers is an odd number, one of the outputs is defined as a redundant output, and the plurality of adders are arranged according to the following structure: An adder is added following a sub-combination at the last stage, and the adder is defined as a second redundant adder. Two input terminals of the second redundancy adder are respectively connected to an output of the last sub-combination and the redundancy output, and reference may be made to the structure shown in FIG. 6.

It should be noted that, the examples shown in FIG. 4, FIG. 5, and FIG. 6 are merely used to facilitate a person skilled in the art to understand the technical solutions of the present application, and cannot be considered as a limitation on a structure of an adder in the present application.

Specifically, when the quantity of the first multipliers is an integer power of 2, a quantity of adders in a sub-combination at a previous stage is twice a quantity of adders in a sub-combination at a current stage, and reference may be made to the structure shown in FIG. 4. In this case, the quantity of the first multipliers is 8, four adders are required for the first sub-combination, two adders are required for the second sub-combination, and one adder is required for the third sub-combination.

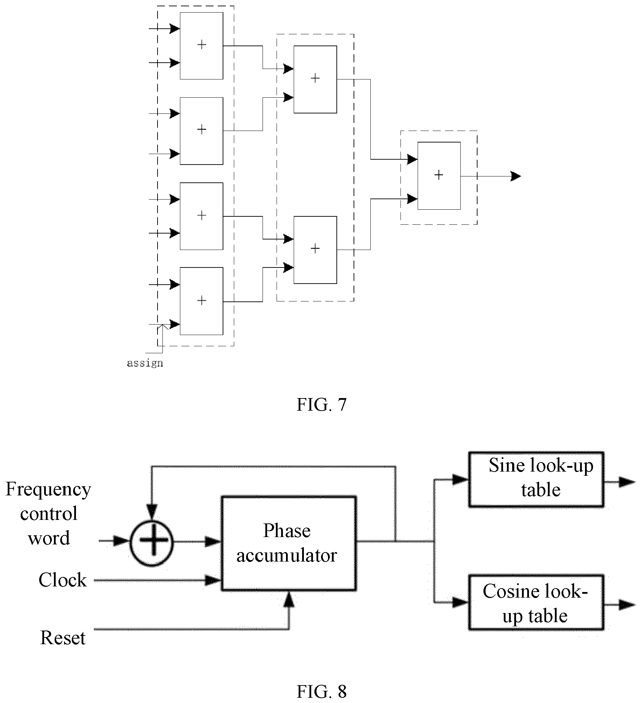

When the quantity of the first multipliers is not an integer power of 2, for example, when the quantity of the first multipliers is 9, reference may be made to the structure shown in FIG. 6. Four adders are still set for the first sub-combination, two adders are required for the second sub-combination, and one adder is required for the third sub-combination. In this case, an output of the third sub-combination and remaining one output of the first multiplier are input to the fourth sub-combination as input signals, and the fourth sub-combination requires one adder. In addition to the foregoing adaptive adjustment on the structure of the adder, the inventors also found that an extra addition may be performed in Verilog by directly using an assign syntax based on a characteristic of the FPGA. For a specific principle, reference may be made to FIG. 7. In other words, when an addition operation is performed, an extra output of the first multiplier is added to any another output and both outputs are combined by using the assign syntax. In such as design, a delay in data processing may be reduced, and the structure shown in FIG. 4 may be still referenced. It may be understood by a person skilled in the art that, although in theory, all outputs may be added together and combined together in a clock cycle by using the assign syntax to implement summation of all numbers, a clock frequency limitation makes implementation impossible.

In this embodiment, the frequency mixing module includes a numerically controlled oscillator (NCO) and a second multiplier, where the numerically controlled oscillator is configured to output a local oscillator signal; and the second multiplier is configured to perform multiply the local oscillator signal and the sampled signal to output the mixed signal.

Specifically, the numerically controlled oscillator (NCO) is also referred to as a direct digital synthesizer (DDS). A main function of the NCO is to generate a sine/cosine waveform sequence with frequency and phase adjustable, and relatively good data precision can be ensured. Implementation methods of the NCO mainly include a real-time calculation method and a table lookup method. It is difficult for the real-time calculation method to balance calculation accuracy and calculation time overheads when a waveform with relatively high frequency is generated. A system used herein requires the NCO to provide high-frequency local oscillator signals for the mixer, which require high speed and precision. Therefore, the table lookup method is used to implement replacement of time with space, that is, to calculate waveform values of each point in advance by using a phase point as an independent variable, and the waveform values are converted to binary and addressed and stored in a phase sequence. A main implementation principle is shown in FIG. 8. Main components of the NCO include a reference clock ($f_{clk}$), a phase word register, a phase accumulator, an amplitude-to-phase conversion circuit, and the like. A frequency control word is actually a fixed phase step calculated based on a target frequency, and is accumulated every reference time period to a value stored in the phase word register. This value is used as an addressing input of a lookup table, and waveform amplitude data at a corresponding time point may be obtained. It should be noted that, the NCO adapting to the system herein should be transformed into an 8-channel parallel output mode. Eight pieces of waveform amplitude data are retrieved in parallel in each clock cycle, so as to generate any sine or cosine sequence with a frequency with 800 MHz or below.

An output frequency $f_{out}$ is determined by a value of an output $\Delta\varphi$ of the phase accumulator and a frequency $f_{clk}$ of the system, and a relationship therebetween is as follows:

$$f_{out} = f_{clk}\Delta\varphi/2^N;$$

where N is a bit number of the phase register, and a higher bit number indicates higher phase precision and a higher frequency resolution ($f_{res}$). A specific relationship is as follows:

$$f_{res} = f_{clk}/2^N;$$

The output of the phase accumulator progresses evenly with time, which may be used as an address input of a read-only memory look-up table (ROM LUT) in which sine and cosine waveform sampling is stored in advance, then a target waveform sampling point is found by using the look-up table, and quantized data of a required waveform data point is output by the ROM. For the quantum state readout system herein, it needs to make the NCO module generate two-channel sinusoidal and cosine signals having a same frequency but a phase difference of $\pi/2$ as a target bit readout cavity by setting an appropriate frequency control word, so as to provide a standard carrier for mixing I-Q channels with an original sampled signal.

Corresponding to the I-Q channels, the second multiplier is also divided into two channels, and one of the multipliers is used as an example. Inputs of the two multipliers are respectively an original signal and a waveform generated from the NCO, and an output of the second multiplier is the output of the frequency mixing module.

Still referring to FIG. 2, in this embodiment, the determining module includes a position determiner and a state determiner. The position determiner is configured to substitute the demodulated signal into the state classification equation to output a first numerical value. The position determiner substitutes a result of the demodulation module into a preconfigured state classification equation, and outputs a single value. Assuming that a state classification equation obtained in a parameter preparation stage is $ax + by + c = 0$, where a, b, and c are coefficients of the state classification equation, and x and y are from a result ($I$, $Q$) of the demodulation module, a value output after the position determiner performs the operation is $output = aI + bQ + c$. The state determiner is configured to output the corresponding quantum state information based on the first numerical value. The state determiner is mainly configured to determine a symbol bit that is from a value result of the position determiner, and an output is 1-bit data, either 1 or 0, which may be respectively corresponding to state 0 and state 1 of a single qubit. In this embodiment, the quantum state information processing system may further include an enabling module, and the enabling module is configured to provide an enabling signal for each module in the quantum state information processing system based on an operating time of the quantum-state information processing system. This module is mainly responsible for selecting a start time and an end time for an effective operation of the quantum state information processing system. For example, if a readout time is preset to 1 $\mu s$, a data segment that needs to be processed spans only 200 clock cycles, and an enabling signal of an accumulator in the demodulation module is generated by the enabling module. In addition, due to a problem of phase alignment between a playback waveform in the NCO and a measured signal waveform, the enabling module also needs to design an appropriate enabling signal group, to control a start time and an end time of waveform playback and operation for coordination.

Further, since the inventors also noted that, a bit width of a signal is expanded to prevent overflow in an operation process of mixing, filtering, integration, and the like, a waveform length is not divided in the integration and accumulation operation, and the bit width exceeds 50 bits after several layers of multiplication and accumulation, resulting in a large number of redundant bits unnecessarily occupying many additional computing resources. The quantum state information processing system provided in the present application further uses a bit width control module to truncate the demodulated signal based on a binary shift operation to adjust a bit width of the demodulated signal. Unnecessary data bits are truncated, and a matching problem between data is uniformly processed, so as to ensure that a correct operation result is output, thereby saving a large amount of computing resources. Specifically, the quantum state information processing system may further include a bit width control module, and the bit width control module is configured to truncate the demodulated signal based on the binary shift operation to adjust the bit width of the demodulated signal.

Based on a same inventive concept, an embodiment further provides a quantum measurement and control system, including the quantum state information processing system according to any one of the foregoing feature descriptions, where the quantum state information processing system is configured to acquire corresponding quantum state information from output information of a qubit.

Based on a same inventive concept, an embodiment further provides a quantum computer, including the quantum measurement and control system in the foregoing feature descriptions.

In the description of this specification, the description with reference to the terms "an embodiment", "some embodiments", "an example", "a specific example" or the like means that specific features, structures, materials, or characteristics described in combination with the embodiments or examples are included in at least one embodiment or example of the present disclosure. In this specification, the schematic representation of the foregoing terms does not necessarily refer to a same embodiment or example. Moreover, the described specific features, structures, materials, or characteristics may be combined in any one or more embodiments in an appropriate manner. In addition, different embodiments or examples described in this specification may be combined and grouped by those skilled in the art.

The foregoing are merely preferred embodiments of the present disclosure, and have no limitation to the present disclosure. Any variation, such as equivalent replacement or modification, made by a person skilled in the art to the technical solutions and technical content disclosed in the present disclosure without departing from the scope of the technical solutions of the present disclosure shall belong to content of the technology solutions of the present disclosure and still belong to the protection scope of the present disclosure.

**Claims**

1. A quantum state information processing system, wherein quantum state information is comprised in an analog signal collected from a qubit, and the quantum state information processing system comprises:

   a sampling module, configured to perform sampling processing on the analog signal to output a sampled signal;
   a frequency mixing module, configured to perform mixing processing on the sampled signal to output a mixed signal;
   a demodulation module, configured to perform demodulation processing on the mixed signal to output a demodulated signal; and
   a determining module, configured to perform state classification on the demodulated signal by using a state classification equation, to output the corresponding quantum state information, wherein the state classification equation is preconfigured and used to distinguish from different quantum states.

2. The quantum state information processing system according to claim 1, wherein the demodulation module comprises:

   a filter, configured to perform filtering processing on the mixed signal to output a filtered signal; and
   an accumulator, configured to perform integration processing on the filtered signal according to an operating time of the filter to output the demodulated signal.

3. The quantum state information processing system according to claim 2, wherein the filter comprises N adders, the N adders are classified into a plurality of sub-combinations, and adders in each sub-combination synchronously execute an addition operation.

4. The quantum state information processing system according to claim 3, wherein the filter further comprises a first multiplier, the plurality of sub-combinations are connected in a cascaded manner, the first sub-combination of the filter comprises $\lceil N/2 \rceil$ adders, input of the first sub-combination is output of the first multiplier, and input of a sub-combination at a current stage in cascade is output of a sub-combination at a previous stage.

5. The quantum state information processing system according to claim 1, wherein the frequency mixing module comprises:

   a numerically controlled oscillator, configured to output a local oscillator signal; and
   a second multiplier, configured to multiply the local oscillator signal and the sampled signal to output the mixed signal.

6. The quantum state information processing system according to claim 1, wherein the determining module comprises:

   a position determiner, configured to substitute the demodulated signal into the state classification equation to output a first numerical value; and
   a state determiner, configured to output the corresponding quantum state information based on the first numerical value.

7. The quantum state information processing system according to claim 1, further comprising:
   an enabling module, configured to provide an enabling signal for each module in the quantum state information processing system based on an operating time of the quantum-state information processing system.

8. The quantum state information processing system according to claim 1, further comprising:
   a bit width control module, configured to truncate the demodulated signal based on a binary shift operation to adjust a bit width of the demodulated signal.

9. The quantum state information processing system according to claim 1, wherein the sampling module comprises an ADC.

10. The quantum state information processing system according to any one of claims 1 to 9, wherein the sampling module, the frequency mixing module, the demodulation module, and the determining module are implemented by using an FPGA, a DSP, or an MCU.

11. A quantum measurement and control system, comprising the quantum state information processing system according to any one of claims 1 to 10, wherein the quantum state information processing system is configured to acquire corresponding quantum state information from output information of a qubit.

12. A quantum computer, comprising the quantum measurement and control system according to claim 11.

FIG. 1

FIG. 2

FIG. 3

FIG. 4

FIG. 5

FIG. 6

FIG. 7

FIG. 8

## INTERNATIONAL SEARCH REPORT

International application No.

**PCT/CN2022/096176**

### A. CLASSIFICATION OF SUBJECT MATTER

G06N 10/00(2022.01)i

According to International Patent Classification (IPC) or to both national classification and IPC

### B. FIELDS SEARCHED

Minimum documentation searched (classification system followed by classification symbols)

G06N

Documentation searched other than minimum documentation to the extent that such documents are included in the fields searched

Electronic data base consulted during the international search (name of data base and, where practicable, search terms used)

CNTXT, CNKI, ENTXT, DWPI: 量子, 模拟, 信号, 采样, 混频, 解调, 方程, 分类, 滤波, 加法器, 乘法器, quantum, analog, signal, sampling, mixing, demodulation, equation, classification, filter, adder, multiplier

### C. DOCUMENTS CONSIDERED TO BE RELEVANT

| Category* | Citation of document, with indication, where appropriate, of the relevant passages | Relevant to claim No. |
|---|---|---|
| X | CN 112884154 A (ORIGIN QUANTUM COMPUTING TECHNOLOGY CO., LTD.) 01 June 2021 (2021-06-01) <br> description, paragraphs [0007]-[0130] | 1-12 |
| A | CN 111353607 A (ORIGIN QUANTUM COMPUTING TECHNOLOGY CO., LTD.) 30 June 2020 (2020-06-30) <br> entire document | 1-12 |
| A | CN 110675716 A (EAST CHINA NORMAL UNIVERSITY) 10 January 2020 (2020-01-10) <br> entire document | 1-12 |
| A | US 2019102691 A1 (IBM) 04 April 2019 (2019-04-04) <br> entire document | 1-12 |

☐ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **20 July 2022** | **26 July 2022** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT
### Information on patent family members

International application No.

**PCT/CN2022/096176**

| Patent document cited in search report | | | Publication date (day/month/year) | Patent family member(s) | | | Publication date (day/month/year) |
|---|---|---|---|---|---|---|---|
| CN | 112884154 | A | 01 June 2021 | None | | | |
| CN | 111353607 | A | 30 June 2020 | CN | 111353607 | B | 07 September 2021 |
| CN | 110675716 | A | 10 January 2020 | CN | 110675716 | B | 25 June 2021 |
| US | 2019102691 | A1 | 04 April 2019 | CN | 111133459 | A | 08 May 2020 |
| | | | | WO | 2019063116 | A1 | 04 April 2019 |
| | | | | US | 2020065696 | A1 | 27 February 2020 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110625588X